(19) Europäisches Patentamt
European Patent Office
Office européen des brevets

(11) EP 0 862 220 A1

(12) **EUROPEAN PATENT APPLICATION**

(43) Date of publication:
02.09.1998 Bulletin 1998/36

(51) Int Cl.$^6$: **H01L 29/739**

(21) Application number: 98301292.3

(22) Date of filing: 23.02.1998

(84) Designated Contracting States:
**AT BE CH DE DK ES FI FR GB GR IE IT LI LU MC NL PT SE**
Designated Extension States:
**AL LT LV MK RO SI**

(30) Priority: 28.02.1997 JP 45174/97

(71) Applicant: **HITACHI, LTD.**
**Chiyoda-ku, Tokyo 100 (JP)**

(72) Inventors:
• **Nagasu, Masahiro**
**Hitachinaka-shi, Ibaraki 312-0061 (JP)**
• **Kobayashi, Hideo**
**Hitachi-shi, Ibaraki 319-1221 (JP)**

• **Uchino, Yoshihiro**
**Hitachi-shi, Ibaraki 316-0006 (JP)**
• **Sakurai, Naoki**
**Hitachi-shi, Ibaraki 319-1221 (JP)**
• **Sakano, Junichi**
**Hitachi-shi, Ibaraki 316-0024 (JP)**
• **Mori, Mutsuhiro**
**Mito-shi, Ibaraki 310-0842 (JP)**

(74) Representative: **Calderbank, Thomas Roger et al**
**MEWBURN ELLIS**
**York House**
**23 Kingsway**
**London WC2B 6HP (GB)**

(54) **Semiconductor switching device and a power converter using the same and a drive method therefor**

(57) The loss of IGBTs is minimized by provision of local life time controlled region in the end portion of depletion layer extending from main junction. The voltage drop during on-state is reduced since the life time is shortened only locally. Further, at the time of turn-off, since the life time in the end portion of the depletion layer on the side of the p collector layer becomes shortened, the carriers present outside the depletion layer which cause to increase the turn-off loss can be eliminated in a short period of time, thereby minimizing the turn-off loss.

FIG.1

## Description

The present invention relates to a circuit and a semiconductor device for use in a power conversion apparatus

A conventional power converter which uses switching devices and rectifying devices carries out its power conversion through their current switching operations. Therefore, there occurs a loss of power due to a large current which flows through these devices during on-state, and a turn-off loss due to a change from their on-state to off-state.

Bipolar devices such as IGBTs are ensured to have a low on-voltage by accumulation of electrons and holes in its low impurity concentration semiconductor layer which functions to retain a voltage applied to the device at normally off-state (which is comprised of a normally low concentration n-type semiconductor layer, and which will be referred to as n-base layer). The on-voltage can be decreased by increasing the quantity of accumulation of electrons and holes therein. On the other hand, however, such charges accumulated will result in a loss of power at the time of turn-off, thereby increasing its turn-off loss with a decreasing on-voltage. Therefore, in a practical application to a power converter, its on-voltage is determined appropriately in consideration of its operating frequency and power source voltage such that a sum of a normally on-state loss, a turn-off loss which occurs when the device is turned-off and a turn-on loss which occurs when the device is turned-on from its off-state becomes minimum.

A value of on-voltage of the device can be controlled by increasing or decreasing the amount of accumulation of electrons and holes in the n-base layer and which can be achieved by adjusting a lifetime in the n-base layer. Conventionally, the life-time control in the device by irradiation of electrons has been practiced. Electrons easily penetrate a substance, and are capable of penetrating through a semiconductor device having a thickness from 300 to 800 μm such as to form uniform lattice defects therein. However, there is such a problem that since the life time in the n-base layer is shortened uniformly, its on-voltage tends to increase substantially.

IEEE Transaction paper, EDD-96-107, pp.53-59 (1996) discloses a study dealing with such a problem described above by locally controlling the lifetime through irradiation of light-weight ions such as helium or protons. Among such attempts, there is a case in which both the on-voltage and the turn-off loss have been reduced compared to the uniform lifetime control by the electron irradiation method, however, it is noted that its effect varies substantially from device to device.

Further, when IGBTs are used to construct a power converter, there results in a problem that a voltage oscillation occurs at the time of turn-on of the device which results in an electromagnetic noise which causes malfunction of its controller. As a result of detailed study of such event, it is clarified that this voltage oscillation is triggered by a rapid drop of a recovery current in a diode which causes resonance between inductance in the main circuit and a capacitance component of the diode. In particular, this problem of resonance was remarkable in a punch-through type IGBT having a short turn-on time wherein a depletion layer which expands in the n-base layer reaches its n-type buffer layer.

An object of the invention is to solve the problems associated with the prior art and to provide a semiconductor switching device which minimizes the on-state loss and turn-off loss. Another object of the invention is to provide a drive method for driving a power converter which minimizes the on-state loss and turn-off loss in semiconductor switching devices. A still further object of the invention is to provide a power converter which can minimize the on-state loss and the turn-off loss in its semiconductor switching devices. A still another object of the invention is to provide a power converter and a semiconductor device which can minimize the on-state loss and turn-off loss in its semiconductor switching devices, and prevent the occurrence of voltage oscillation therein.

The objects of the invention described above can be accomplished by provisions of a semiconductor switching device (hereinafter referred to as switching device), a power converter and a drive method for driving the power converter to be described in the following.

In a switching device to be used in the power converter and the drive method for driving the power converter according to the invention, a carrier life time is ensured to decrease locally therein. Further, this switching device is applied with a power source voltage which causes a depletion layer therein to extend to a position of the local life time controlled portion.

Further, in the power converter and the drive method thereof, the switching device which has a locally controlled life time portion and a diode which does not punch through at the power source voltage are used in combination as connected in reverse parallel.

Now, the features of the power converter and the drive method thereof according to the invention that a power loss and switching noise can be minimized will be described in the following.

By and large, the turn-off loss will increase when a tail current which appears at the time of turn-off becomes longer. The tail current originates from carriers having been accumulated in the base during on-state and from carriers remaining in the outside of the depletion layer which expands from a main junction. Of these carriers in the base, those in a region which is included in the depletion layer are discharged in a short period of time by electrical field applied. On the other hand, a speed of elimination of carriers remaining outside the depletion layer which are eliminated through recombination is gradual. Therefore, the carriers remaining outside the depletion layer induce a carrier injection from a collector layer over a long period of time. According to the invention, however, since its depletion layer is allowed to expand such as to include the region having a relatively longer life time, carriers accumulated in this region, how much they may be, can be discharged in a short period of time by the electrical field of the depletion layer, thereby without affecting the turn-off loss. Thereby, its on-voltage can be decreased without affecting the turn-off loss. Still further, since a position which the end of the depletion layer reaches is provided with the life time control, carriers outside the depletion layer can be reduced substantially. Thereby, the tail current becomes small and the turn-off loss is minimized. As described above, since both the on-voltage and the turn-off losses of the switching device according to the invention can be minimized, a power loss of the power converter can be reduced substantially.

Generally, it is noted that when the diode which is connected to the switching device in reverse parallel in the power converter undergoes a recovery step, and when a rate of changes in its recovery current going down from its peak value to its zero current state is great, there tends to occur an overvoltage due to circuit inductance. This overvoltage is applied to the diode tending it to punch through. The diode when punched through acts equivalently as a capacitance, thereby causing a sharp resonance phenomenon with inductance of the main circuit wiring, thereby causing a noise to occur. According to the invention, however, since a diode of a non-punch through type which does not punch through at the power source voltage is utilized, attenuation of the recovery current at its recovery becomes slow due to accumulated carriers, thus the occurrence of the noise can be suppressed.

By way of example, this reverse parallel connection of the switching device and the diode according to the invention can be applied also to modular type semiconductor devices such as IGBT power modules and the like to the same effect and advantages.

Other and further objects, features and advantages of the invention will appear more fully from the following description with reference to the accompanying drawings, wherein:

Figs. 1(a) and 1(b) show an IGBT of an embodiment according to the invention, and Fig. 1(a) depicts its device structure and Fig. 1(b) depicts a depletion layer and electrical field expanding within the device;

Figs. 2 (a) and 2(b) show a power converter according to the invention, and Fig. 2(a) depicts its circuit configuration and 2(b) depicts a power supply voltage which ensures the advantages of the invention to be obtained;

Figs. 3(a) and 3(b) show a relationship between positions of the local life time control and their power losses;

Figs. 4(a) and 4(b) show a combination of IGBT and a diode in order to prevent electromagnetic noise according to the invention, and, in particular, 4(a) depicts its IGBT and 4(b) depicts its diode;

Fig. 5 shows waveforms of each part in Fig. 1, and explains how the electromagnetic noise can be suppressed by the combination of Fig. 4;

Figs. 6(a) and 6(b) show a circuit configuration of the invention, and a module which combines IGBT and the diode;

Fig. 7 shows another embodiment of the invention;

Figs. 8(a) and 8(b) show still other embodiments of the invention;

Fig. 9 shows still more embodiment of the invention; and

Fig. 10 is an example of the invention which is applied to a power converter for driving a three-phase induction motor.

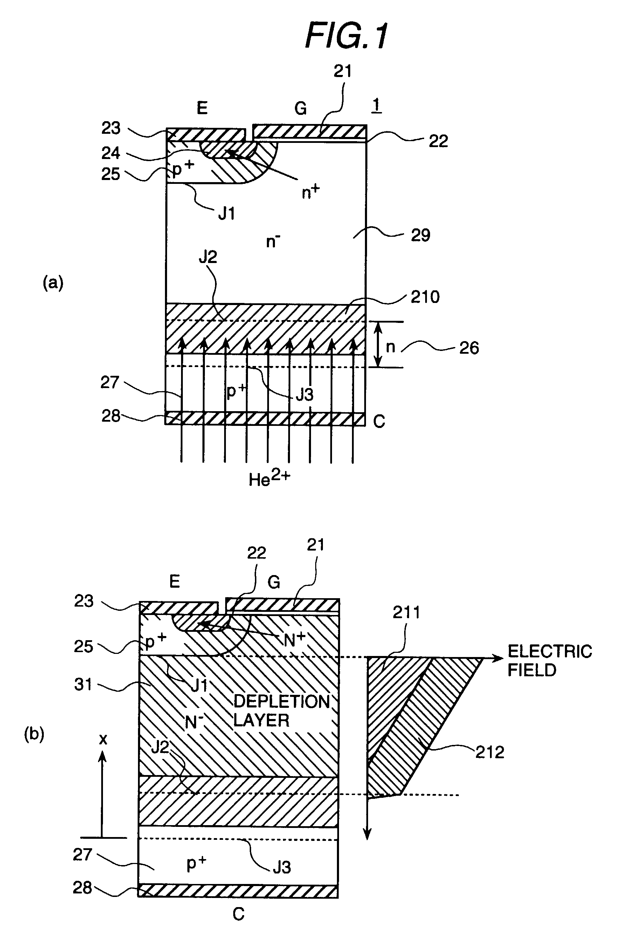

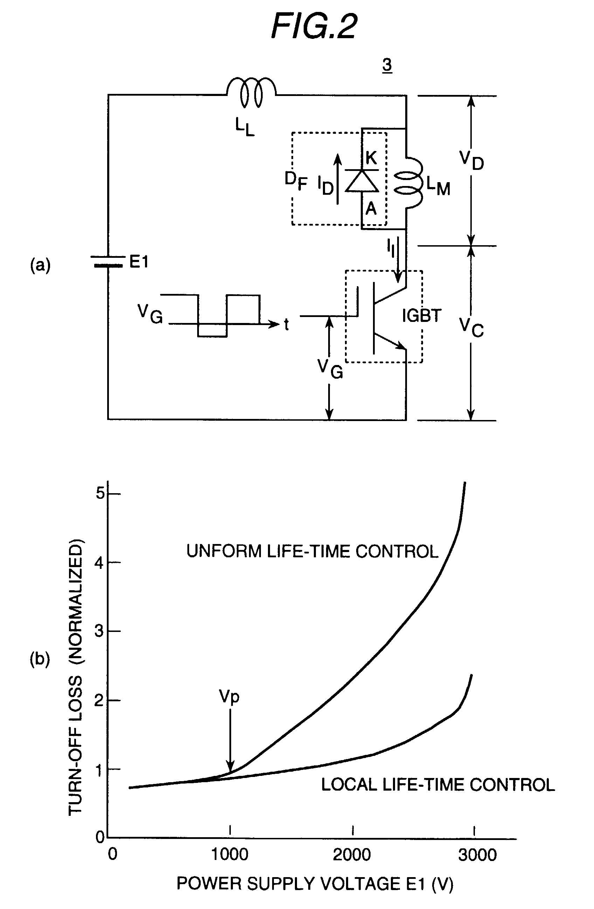

With reference to Figs. 1 and 2, an embodiment of the invention will be described in the following. Figs. 1(a) and 1(b) show an insulated gate bipolar transistor (hereinafter referred to as IGBT) which is a switching device according to one embodiment of the invention.

Fig. 1(a) depicts an IGBT according to the invention which is comprised of: $p^+$ conducting type semiconductor layer 25 in contact with $n^-$ conducting type semiconductor layer 29; $n^+$ conducting type semiconductor layer 24 in contact with the $p^+$ conducting type semiconductor layer 25; emitter electrode 23 in contact with $p^+$ conducting type semiconductor layer 25 and $n^+$ conducting type semiconductor layer 24; insulation layer 22 which is in contact with $n^+$ conducting type semiconductor layer 24, $p^+$ conducting type semiconductor layer 25 and $n^-$ conducting type semiconductor layer 29; gate electrode 21 in contact with insulation layer 22; further, n conducting type semiconductor layer 26 in contact with $n^-$ conducting type semiconductor layer 29; $p^+$ conducting type semiconductor layer 27 in contact with n conducting type semiconductor layer 26; and collector electrode 28 in contact with $p^+$ conducting type semiconductor layer 27. Further, Fig. 1(b) depicts depletion layer 31 which expands within $n^-$ conducting type semiconductor layer 29 when IGBT is off-state, and also electrical field distributions 211 and 212 within the depletion layer, 211 represents a case where depletion layer 31 does not reach n conducting type semiconductor layer 26, and 212 represents a case where depletion layer 31 reaches n conducting type semiconductor layer 26. In this arrangement of IGBT, a local life time controlled portion 210 is provided adjacent to the end of the depletion layer on the side of collector electrode 28. Figs. 1(a),(b) show an example of such a local life time controlled portion which is provided in an area which partially includes both $n^-$ conducting type semiconductor layer 29 and n conducting type semiconductor layer 26, and this area of the local life time controlled portion is where it is most effective to realize the advantage of the invention.

Now, with reference to Figs. 2(a) and 2(b), features and advantages of this IGBT of the invention will be described when it is applied to a power converter. In Fig.

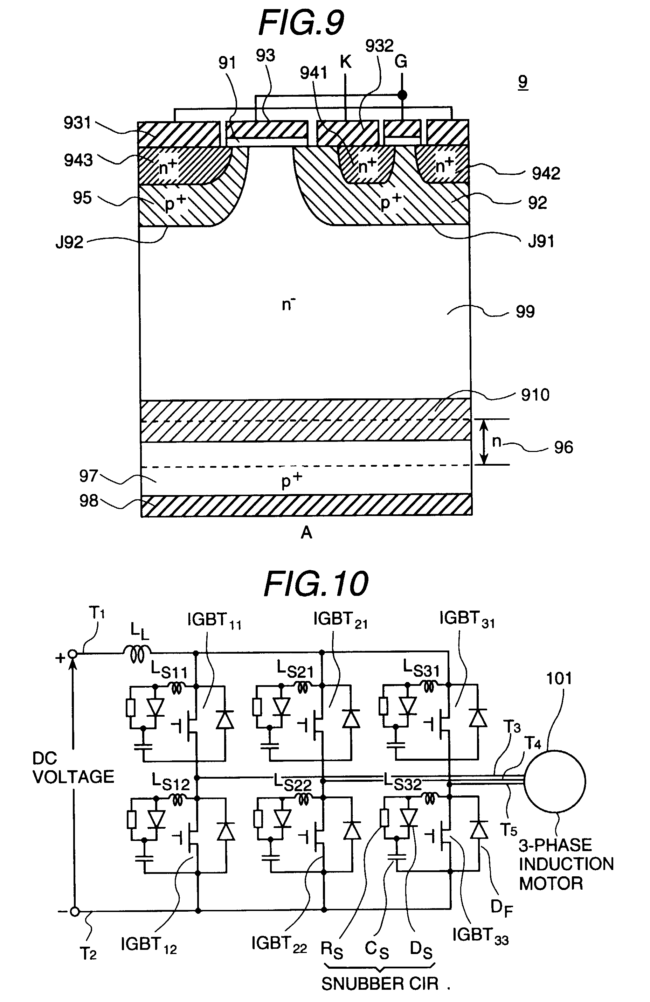

2(a), numeral 3 depicts an example of power converter which has a circuit configuration comprising: a parallel circuit of diode $D_F$ and load inductance $L_M$; power supply E1; inductance $L_L$ of a main circuit wiring; and switching device IGBT, all of which connected in series. This circuit configuration corresponds to one phase of a power converter in Fig. 10, and two parts of diode $D_F$ and IGBT encircled by dotted lines are actually connected in reverse parallel. Further, inductance $L_M$ corresponds to an inductance of a three-phase induction motor.

Fig. 2(b) shows a dependency of turn-off losses in IGBTs on power supply voltages. Vp which will be described more in detail later indicates a punch-through voltage at which the depletion layer in IGBT of Fig. 1 which expands from a main junction J1 reaches junction J2 between n⁻ conducting type semiconductor layer 29 and the n conducting type semiconductor layer 26. Axis of ordinates in Fig. 2(b) indicates normalized turn-off losses which are normalized by the turn-off loss which was obtained using the IGBT of Fig. 1 which was applied a uniform life time control and subjected to switching operation at 1000 V of power supply. Here, the uniform life time control refers to a case where the life time in IGBT is uniformly controlled by electron irradiation. On the other hand, the local life time control refers to a case where the life time in the device is controlled to become shorter in a specified local area by irradiation of light-weight ions such as proton or helium as indicated with reference to Fig. 1. By way of example, a preferred portion in the device to be applied with the local life time control is an area which partially includes both n⁻ conducting type semiconductor layer 29 and n conducting type semiconductor layer 26, and into this area the ions are irradiated preferably from the side of collector electrode 28.

When IGBT is on-state, a current flows in the main circuit through inductance $L_L$, load inductance $L_M$ and IGBT. When applied with an off-gate signal, IGBT becomes off-state, thereby interrupting the current in the main circuit. However, a current flowing through load $L_M$ continues to flow by circulating through free wheeling diode $D_F$. Then, when IGBT becomes on-state again, a current starts to flow through inductance $L_L$, load $L_M$ and IGBT. A power converter operates to transfer energy to load $L_M$ by the switching operation of IGBT as described above. However, there arise turn-on and turn-off losses in transition of IGBT from its on-state to off-state and vise versa.

A detailed study on the turn-off losses relative to the power supply voltages revealed a relationship therebetween as indicated in Fig. 2(b). A turn-off loss of IGBT which was provided with a local life time control increased gradually with an increasing voltage, while one the other hand, a loss of IGBT which was provided with a uniform life time control increased rapidly from voltage Vp. As a result of study on the significance of this voltage, it is found to correspond to a punch-through voltage in IGBT as will be described below. An impurity concentration of n⁻ conducting type semiconductor layer 29 of IGBT was measured to be $1.1 \times 10^{13} \text{cm}^{-3}$, a thickness (from J1 to J2) was 350 μm, and an impurity concentration of p⁺ conducting type semiconductor layer 25 was as high as approximately $10^{17} \text{cm}^{-3}$. Thereby, depletion layer 31 is allowed to expand only within n⁻ conducting type semiconductor layer 29, and a width of the depletion layer Wd (cm) becomes as follows.

$$Wd = ((2 \cdot \varepsilon s \cdot V)/(q \cdot Nn^-))^{0.5} \quad (1),$$

where, $\varepsilon s$ (F/cm) is a dielectric constant of an IGBT substrate, V(V) is a voltage applied, q(C) is a quantity of charge of electrons, and Nn⁻ ($\text{cm}^{-3}$) is an impurity concentration of n⁻ conducting type semiconductor layer 29. Since the dielectric constant of Si is $1.05 \times 10^{-12} \text{F/cm}$, the quantity of charge of electron q is $1.602 \times 10^{-19} \text{C}$, and width Wd of the depletion layer is 345 μm when voltage V is 1000 V, Vp is defined to be a voltage at which depletion layer 31 is caused to reach n conducting type semiconductor layer 26, namely, a punch-through voltage.

In the IGBT according to the invention, its turn-off loss is decreased through provision of the local life time control portion which is provided in the vicinity of a boundary between n⁻ conducting type semiconductor layer 29 and n conducting type semiconductor layer 26, i.e., in the end portion of the depletion layer on the side of collector electrode 28.

At the time of turn-off, IGBT cannot interrupt its current instantaneously, and allows a tail current to flow. This tail current is caused by discharging of carriers having been accumulated within the device during on-state. However, according to the study by the present inventors, it is caused not only by such accumulated carriers but also by injection of holes from p⁺ conducting type semiconductor layer 27.

At the time of turn-off, depletion layer 31 is caused to expand from main junction J1 toward collector electrode 28, and at the same time, holes are caused to move to p⁺ conducting type semiconductor layer 25 and electrons are caused to move to n conducting type semiconductor layer 26. Depletion layer 31 having expanded is fixed at a width which is determined by power supply voltage El. However, since holes out of carriers present outside the depletion layer continue to flow into the depletion layer 31, injection of holes from p⁺ conducting type semiconductor layer 27 continues so as to prevent occurrence of excessive electrons therein, thereby resulting in a large turn-off loss. In IGBT with the local life time controlled portion provided in the end portion of depletion layer 31, since carriers remaining in the end portion of the depletion layer can be eliminated in a short period of time, the amount of holes moving into the depletion layer is minimized, thereby resulting in a reduced turn-off loss.

The power supply voltage to be applied to IGBTs of the invention will vary depending on its field of application, thereby, the position of its local life time controlled portion must be modified in accordance with its power supply voltage. However, for IGBT having a structure provided with n conducting type semiconductor layer 26 as indicated in Fig. 1, such modification is not required. For example, in IGBTs wherein an impurity concentration of n⁻ conducting type semiconductor layer 29 is 1.1 x $10^{13}$cm⁻³ and its thickness is 350 μm, its depletion layer 29 reaches n conducting type semiconductor layer 26 at an applied voltage of 1000 V. Therefore, provided that the boundary area between n⁻ conducting type semiconductor layer 29 and the n conducting type semiconductor layer 26 is applied with a local life time control, and at a power supply voltage of 1000 V or greater, it is ensured that the end portion of the depletion layer is positioned in the local life time controlled portion so as to minimize its turn-off loss. For this IGBT having n⁻ conducting type semiconductor layer 29 having such impurity concentration and thickness described above, a breakdown voltage of 3-4 kV is normally obtainable, and its power supply voltage applicable in this case is 1200 to 2500 V. Therefore, through provision of the local life time control portion in the boundary area between n⁻ conducting type semiconductor layer 29 and n conducting type semiconductor layer 26, its turn-off loss can be substantially reduced irrespective of its field of applications. As described above, the IGBT according to the invention which is provided with the local life time controlled portion which is formed in the boundary between n⁻ conducting type semiconductor layer 29 and n conducting type semiconductor layer 26 is advantageous if used at a power supply voltage El that satisfies the condition that the depletion layer reaches n conducting type semiconductor layer 26, which is defined by the following equation 2,

$$E1 \geqq ((q \cdot Nn^{-})/(2 \cdot \varepsilon s)) \cdot Wn^{-2} \qquad (2),$$

where Wn⁻(cm) is a thickness of n⁻ conducting type semiconductor layer 29.

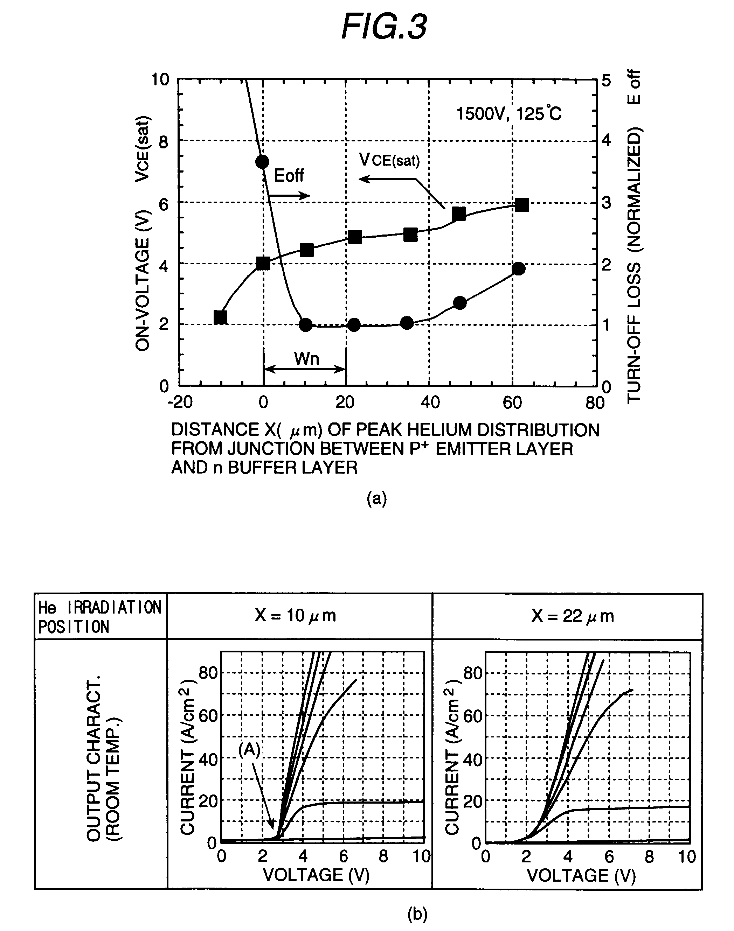

Figs. 3(a) and 3(b) show results of measurements indicative of the effect of the first embodiment of Fig. 1. In Fig. 3(a), axes of ordinate depict normalized turn-off losses on the right-hand side and on-voltages on the lefthand side, and axis of abscissa depicts positions of a local life time controlled portion irradiated with helium in distance (x) from junction J3 between n-conducting type semiconductor layer 26 and p⁺ conducting type semiconductor layer 27. Measurements of turn-off losses are carried out at the power supply voltage 1500 V and the temperature of 125°C, and a value of on-voltage is one when its current density is at 50 A/cm². Further, the turn-off losses are normalized by a minimum value of the losses. By way of example, since helium distribution in the local life time controlled portion takes a Gaussian distribution, a distance (x) in Fig. 3(a) indicates a distance between junction J3 and a peak point in the helium distribution. Fig. 3(b) indicates output characteristics for x=10μm and x=22μm, respectively at room temperatures.

The on-voltage increases remarkably with respect to the position of the local life time controlled portion in ranges from -10 to 0μm and exceeding 35μm. Further, the turn-off loss increases gradually with respect thereto when the distance (x) exceeds 35μm, and increases rapidly when the distance decreases less than 10μm. This is due to the following reasons. By way of example, symbol Wn in the drawing of Fig. 3(a) indicates a width of n-conducting type semiconductor layer 26 which is 20μm. Further, a half value width λ of the helium distribution in the local life time control is 10μm.

When a depth of the local life time controlled portion becomes shallow less than 10μm from junction J3 between n conducting type semiconductor layer 26 and p⁺ conducting type semiconductor layer 27, life time in the portion of the junction J3 becomes shorter. When the life time in this portion of the junction J3 becomes shorter, recombination between electrons and holes becomes vigorous, thereby rapidly deteriorating injection of holes from p⁺ conducting type semiconductor layer 27 to n⁻ conducting type semiconductor layer 29. As a result, there occurs a sharp bending (A) in its output characteristics as indicated in Fig. 3(b). Such characteristics are not desirable since they result in a noise occurrence at the time of turn-on. Further, in this embodiment of the invention, since the local life time control is provided by irradiating helium from the side of collector electrode 28, defects are formed also in a region through which helium passed. When the controlled portion becomes deeper than 35μm, since a short life time portion extends into n⁻ conducting type semiconductor layer 29, on-voltage is caused to increase gradually. Further, when the local life time controlled portion becomes shallower than 10 μm, since the local life time controlled portion moves away from the end of depletion layer 31, the turn-off loss increases rapidly.

When the local life time controlled portion becomes deeper than 35μm, both the on-voltage and the turn-off loss start to increase. This is due to the following reason. As described above, the reason why the turn-off loss is reduced by the local life time control is due to that carriers at the end of the depletion layer expanding from main junction J1 are eliminated in a short period of time thereby instantly stopping hole injection from p⁺ conducting type semiconductor layer 27. When the local life time controlled portion moves away deeply from n conducting type semiconductor layer 26 into n⁻ conducting type semiconductor layer 29, the local life time controlled portion becomes included in depletion layer 31. Thereby, carrier life time at the end of the depletion layer which determines a quantity of carrier injection from p⁺ conducting type semiconductor layer 27 becomes longer, thereby allowing presence of carriers in the end portion for a long period of time, and thereby, causing its tail current to become long, and in consequence, increasing its turn-off loss.

In this embodiment of the invention, helium is irradiated from the side of collector electrode 28. This is because that if it is irradiated from the side of emitter electrode, since life time becomes shortened in any region through which helium is passed, the life time across $n^-$ conducting type semiconductor layer 29 will become shortened, thereby increasing the on-voltage adversely. In contrast, when it is irradiated from the side of collector electrode 28, since the life time across $n^-$ conducting type semiconductor layer 29 will be maintained long, while holding the on-voltage low, only the turn-off loss can be reduced effectively.

As preferred ions which can be used for the local life time control of the invention, there are those of helium, protons, neon and the like, however, helium is more preferable. This is due to the following reason. In IGBTs having a breakdown voltage in a range from 2kV to 6kV, a thickness of $n^-$ conducting type semiconductor layer 29 must be in a range of 200-500μm in order to withstand that voltage. In order to manufacture the device stably, it is preferable for a wafer to have a thickness 500μm or more, and it becomes necessary to increase the thickness of wafer with an increasing size thereof. In actual manufacture of wafers, an overall thickness of wafers is controlled by increasing the thickness of $p^+$ conducting type semiconductor layer 27 using the epitaxial growth method. Further, since the on-voltage will increase when the local life time controlled portion widens, it is preferable for its half value breadth to be approximately at 10μm for reducing the loss. Proton is more transmitting but results in a wider half value breadth while neon results in a narrow half value breadth but is less transmitting. Therefore, in order to be able to inject ions, through $p^+$ conducting type semiconductor layer 27, into an appropriate depth which includes n type semiconductor layer 26 and $n^-$ conducting type semiconductor layer 29, and to ensure a half value breadth of approximately 10μm to be obtained, helium is preferable which has a good transmittance and a narrow half value breadth.

As a result of the discussions above, an appropriate position (x) of the local life time controlled portion for minimizing the power loss of IGBTs can be obtained by the following formula (3),

$$\lambda \leqq x \leqq (Wn + 1.5 \lambda) \qquad (3),$$

where junction J3 between n type semiconducting layer 26 and $p^+$ conducting type semiconductor layer 27 is defined to be x=0, and a direction of $n^-$ conducting type semiconductor layer 29 from junction J3 is defined to be positive. More specifically, in the embodiment of Fig. 3, it is preferable that 10μm≦x≦35μm.

Further, the features and advantages of the local life time control of the invention is more effective in high voltage IGBTs having a breakdown voltage from 2 to 6 kV. In case helium ion is used for providing the local life time control, the loss can be minimized by setting its dosage at a value from $0.7 \times 10^{11}$cm$^{-2}$ to $2 \times 10^{11}$cm$^{-2}$, and the half value breadth $\lambda$ at a value from 5 to 30μm. By way of example, the position (x) of irradiation is in a range which satisfies formula (3).

By way of example, a basic architecture of most of the power converters using IGBTs has a circuit configuration as shown in Fig. 2(a), in which IGBTs are used essentially in combination with diode $D_F$. As described above, when IGBT is used in such condition that depletion layer 31 which expands from main junction J1 is allowed to reach n type conducting semiconductor layer 26, IGBT can demonstrate an extremely fast turn-on speed. In such condition, free-wheel diode $D_F$ tends to generate a noise at the time of its recovery, therefore, it is necessary to provide for characteristics to the diode to ensure the depletion layer not to punch through, which will be described in the following.

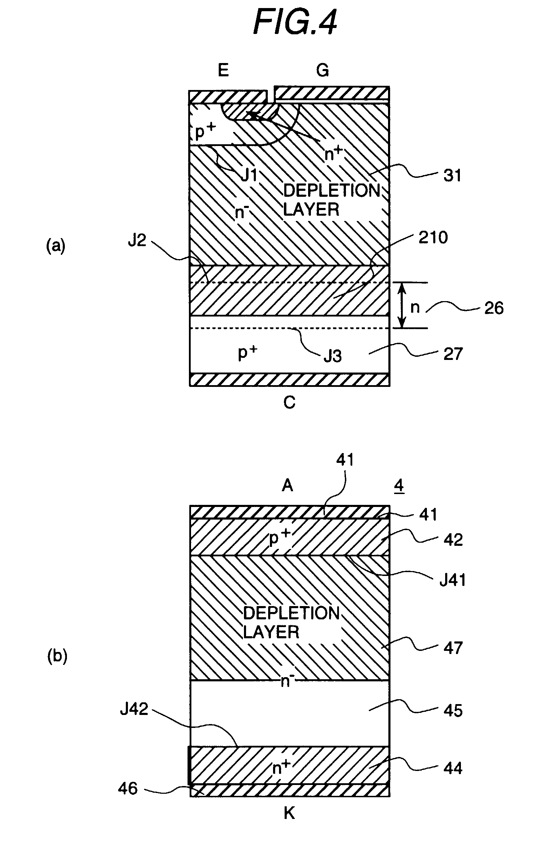

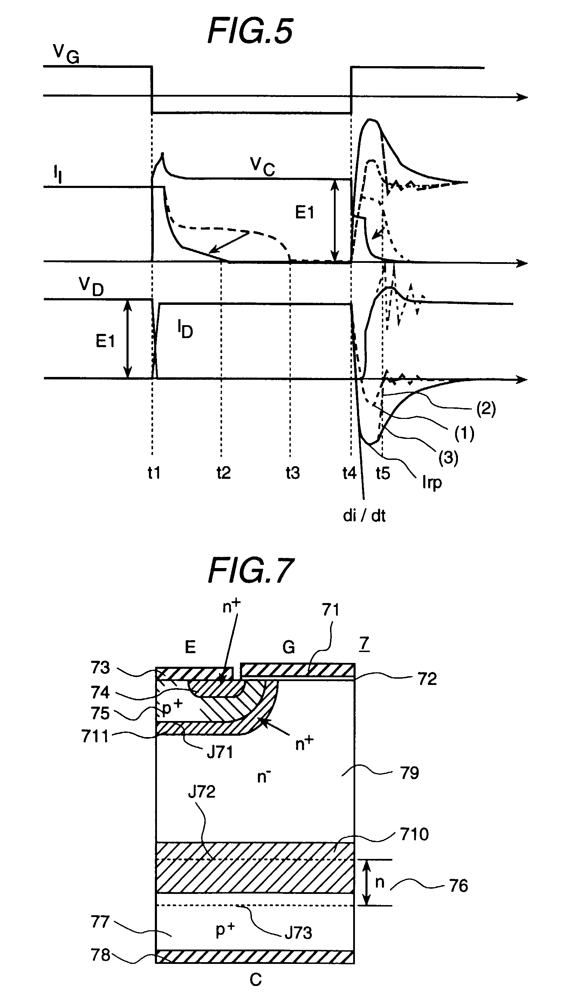

Fig. 4(a) depicts a cross-section of an IGBT, and Fig. 4(b) depicts that of a free-wheel diode $D_F$. The diode is comprised of: $n^-$ conducting type semiconductor layer 45; $p^+$ conducting type semiconductor layer 42 in contact with layer 45; anode electrode 41 in contact with the $p^+$ conducting type semiconductor layer 42; $n^+$ conducting type semiconductor layer 44 in contact with $n^-$ conducting type semiconductor layer 45; and cathode electrode 46 in contact with layer 44. Further, Fig. 5 shows waveforms during operation of the circuit of Fig. 2(a). When a negative voltage is applied at time tl to the gate electrode of switching device IGBT, which IGBT becomes off-state, thereby interrupting its current. A current then flowing through load inductance $L_M$ is caused to circulate free-wheel diode $D_F$ diode. At this time, a tail current flows through IGBT, however, due to the provision of the local life time control instead of the prior art uniform life time control, the time allowed for the tail current to eliminate is shortened from t3 of prior art to t2, thereby substantially reducing the loss.

When IGBT again becomes on-state at time t4, a reverse voltage is applied to the free-wheeling diode. However, carriers having been accumulated in the diode during its forward voltage application flow as a recovery current, thereby the reverse voltage applied to the diode at an initial stage of recovery is maintained low. Then, the recovery current continues to increase, and finally it flows in a negative direction. Upon extinction of the carriers remaining in the diode, a rate of increase di/dt of the recovery current starts to decrease, and together with this decrease, the reverse voltage applied to the free-wheel diode starts to increase. After reaching its peak point, the recovery current decreases with extinction of the carriers within the diode and approaches to zero finally. Further, the voltage applied to the diode becomes equal to the power supply voltage at a time when the recovery current reaches its peak value.

The rate of increase of the recovery current di/dt is determined by the power supply voltage, a voltage to be shared by IGBT at the time of turn-on, and inductance $L_L$ in the main circuit wiring, and will increase with an increasing turn-on speed of IGBT. When used in such condition that depletion layer 31 is allowed to reach semiconductor layer 26, the turn-on speed increases as indicated by a solid line in Fig. 5. Therefore, the peak value of the recovery current is caused to increase from that of dotted line (1) which is the case where its turn-on speed is low, then to that of dotted line (2), and to that of the solid line (3), thereby indicating a tendency for a rate of decrease of absolute values decreasing from their peak values to become faster. Under application of the reverse voltage to the diode, when depletion layer 47 expanding from main junction J41 in the diode indicated in Fig. 4(b) reaches $n^+$ conducting type semiconductor layer 44, the current flowing through the diode becomes extinct. Therefore, the recovery current decreases abruptly at time t5 as indicated by dotted line (2). Since the recovery current also flows through inductance $L_L$, a greater excessive voltage is applied to the free-wheeling diode due to inductance $L_L$ when a rate of decrease in absolute value of the recovery current becomes faster, thereby causing an oscillation as shown in Fig. 5. In order to prevent occurrence of such oscillation, therefore, it is conceived that the abrupt decrease as indicated by dotted line (2) should be avoided.

When depletion layer 47 which expands from main junction J41 in the diode is suppressed from reaching $n^+$ conducting type semiconductor layer 44, carriers are allowed to remain in a region between depletion layer 47 and junction J42 between $n^-$ conducting type semiconductor layer 45 and $n^+$ conducting type semiconductor layer 44, which remaining carriers then flow out of the diode as a tail current. In such case, therefore, the current decreases slowly as indicated by the solid line (3) in Fig. 5, thereby causing no oscillation phenomenon to occur. Therefore, when using IGBT provided with the local life time control and operating the same by applying a power supply voltage at which its depletion layer becomes punched-through, it is preferable to use a diode which will not punch through at that power supply voltage (hereinafter referred to as non punch-through diode).

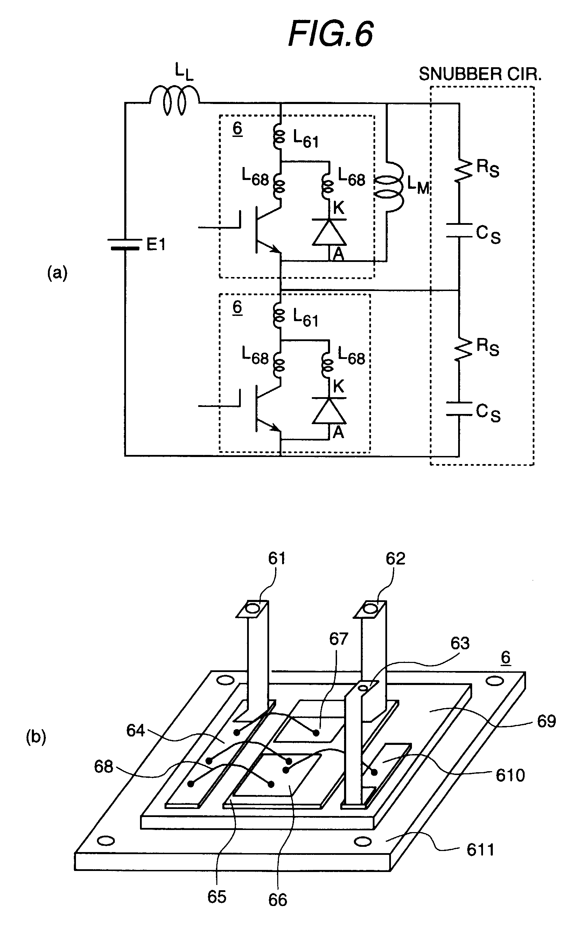

As described hereinabove, there are such features and advantages according to the invention that by operating IGBT provided with the local life time control under application of a voltage which is greater than its punch-through voltage, both the turn-on and the turn-off losses can be reduced simultaneously, and that by combining the IGBT with the non-punch-through diode which will not punch through at the power supply voltage in the construction of a power converter, the occurrence of electromagnetic noise can be prevented. These features and advantages of the invention can be accomplished also by assembling separate circuits of a punch-through IGBT provided with the local life time control and of a non-punch-through diode, however, in most cases, they may be provided in a module circuit combining IGBT 66 and diode 67 in reverse parallel as indicated in Fig. 6(b).

A module structure of Fig. 6(b) represents a portion surrounded by dotted lines in Fig. 6(a). In the drawing of Fig. 6(b), numerals depict that 66: IGBT, 67: diode, 611: base metal, 69: insulator, 65: collector electrode plate, 64: emitter electrode plate, 610: gate electrode plate, 63: gate electrode terminal, 62: collector electrode terminal, and 61: emitter electrode terminal, wherein each connection between each electrode plate and each terminal is connected by aluminum wire 68. Aluminum wires and terminals have each parasitic inductance as indicated in Fig. 6(a), where L61 indicates inductances of emitter electrode 61 and collector electrode 62, and L68 indicates inductance of aluminum wiring. In the case of a module construction, a leap voltage and a noise due to inductance $L_L$ of its main circuit wiring can be prevented by provision of a snubber circuit, however, an excessive voltage and the noise resulting from an inductance in the module cannot be prevented. Therefore, any diode to be incorporated within the module in combination with IGBT which is provided with the local life time control needs to be one which is a non-punch-through diode in which its depletion layer does not punch through even at the power supply voltage. By way of example, the snubber circuit indicated in Fig. 6 (a) is not limited thereto, and any other modification thereof can be used. Further, when inductance $L_L$ of the main circuit wiring is relatively small, and a resulting leap voltage or noise does not cause a problem, the snubber circuit can be omitted.

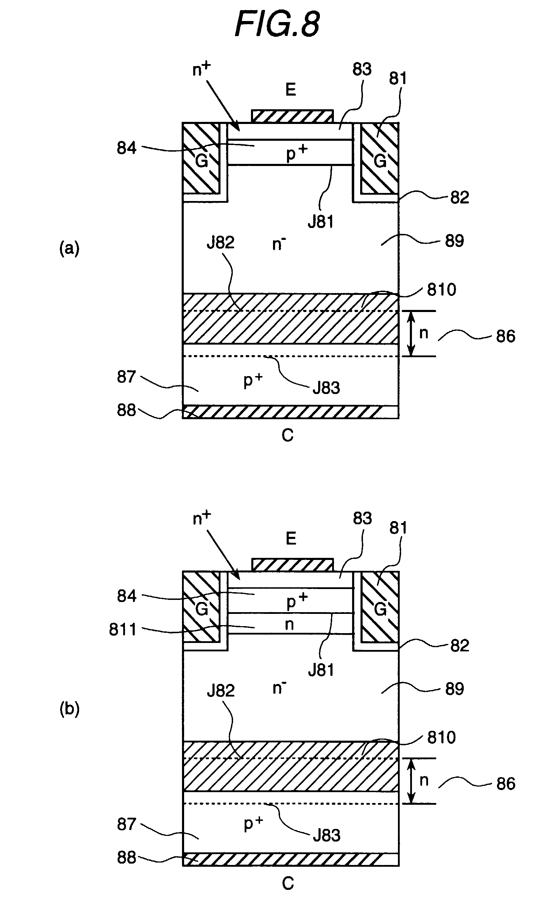

Another embodiment of the invention provided with the local life time control will be described with reference to Fig. 7, which shows a modified version of IGBT of Fig. 1 having $n^+$ conducting type semiconductor layer 711 added thereto. The $n^+$ conducting type semiconductor layer 711 functions to block inflow of holes from $p^+$ conducting type semiconductor layer 77 when the device is on-state, thereby allowing many carriers to be present within $n^-$ conducting type semiconductor layer 79, thereby allowing the on-voltage to become low. This switching device operates in such a manner that when a positive voltage is applied to gate electrode 71, an n-type inversion layer is formed at a boundary between $p^+$ conducting type semiconductor layer 75 and insulation film 72, thus allowing electrons to be injected from $n^+$ conducting type semiconductor layer 74 into $n^-$ conducting type semiconductor layer 79 therethrough, which electrons cause holes to be injected from $p^+$ conducting type semiconductor layer 77 into the layer 79, thereby causing the device to become on-state. On the other hand, when an negative voltage is applied to gate electrode 71, the above-mentioned inversion layer disappears, thereby causing to stop injection of electrons from $n^+$ conducting type semiconductor layer 74, and thereby causing the device to become off-state. Under such circumstance, a depletion layer is caused to expand from junction J71 in the device, and electrons remaining in a region between the end of the depletion layer and junction J73 causes holes to be kept injecting therein from p+ conducting type semiconductor layer 77, and thereby causing a long tail current to flow. Therefore, as in the case of the IGBT of Fig. 1, if there is provided a local life time controlled portion in the end of the depletion layer toward cathode electrode 78, its turn-off loss can be reduced substantially. Further, in Fig. 7, numeral 73 is an emitter electrode which is provided in contact both with p+ conducting type semiconductor layer 75 and n+ conducting type semiconductor layer 74, numeral 71 is a gate electrode provided in contact with insulation film 72, numeral 710 is a local life time controlled portion which is formed to include n conducting type semiconductor layer 76 and n- conducting type semiconductor layer 79, and numeral 78 is a collector electrode. It is the same for the local life time controlled portion of this embodiment of the invention preferably to be provided partially to include both n conducting type semiconductor layer 76 and n- conducting type semiconductor layer 79 as in the case of the IGBT of Fig. 1.

With reference to Figs. 8(a) and 8(b), still other embodiments of the invention will be described, which are applied to IGBTs having a trench gate electrode structure. An IGBT of Fig. 8(a) is comprised of: emitter electrode E; n+ conducting type semiconductor layer 83; p+ conducting type semiconductor layer 84; n- conducting type semiconductor layer 89; n conducting type semiconductor layer 86; p+ conducting type semiconductor layer 87; and collector electrode 88, all of which are stacked in a vertical direction, and the same further comprising: a gate electrode which is formed penetrating through n+ conducting type semiconductor layer 83 and p+ conducting type semiconductor layer 84 such as to reach into n- conducting type semiconductor layer 89; and insulation layer 82 which is provided in the circumference of the gate electrode. In this device described above, the end portion of its depletion layer on the side of cathode electrode 88 is arranged to correspond to the local life time controlled portion, and by applying positive or negative voltages to the gate electrode, the device is operated its switching function alike the IGBT of Fig. 1. Further, with respect to its feature of the low power loss to be achieved, it will be omitted since it is already described. However, its local life time controlled portion is preferably in a region which includes in part both n conducting type semiconductor layer 86 and n- conducting type semiconductor layer 89.

Fig. 8(b) shows another version of the embodiment of IGBT of Fig. 8(a) which is further provided with n conducting type semiconductor layer 811, through which gate electrode 81 penetrates into n- conducting type semiconductor layer 89. In this IGBT, inflow of holes from p+ conducting type semiconductor layer 87 is blocked by n conducting type semiconductor layer 811, thereby readily causing carriers to be accumulated in the layer 89 during on-state, and thereby achieving a low on-voltage. Its operation method is the same as in Fig. 8(a), and its local life time controlled portion is also provided in the same region therein. Description of its feature to attain the low loss is omitted since it is clear from the description hereinabove.

Still further embodiment of the invention is described with reference to Fig. 9. In this device of Fig. 9, when a voltage which is greater than its threshold voltage is applied to gate electrode 93, n+ conducting type semiconductor layer 941, n+ conducting type semiconductor layer 942, and n+ conducting type semiconductor layer 943 are connected to n- conducting type semiconductor layer 99 via n conducting type inversion layer, thereby causing electrons to be injected into n- conducting type semiconductor layer 99 from n+ conducting type semiconductor layer 943 and causing holes to be injected therein from p+ conducting type semiconductor layer 97, respectively, and thereby executing its turn-on operation. When the voltage to be applied to gate electrode 93 decreases below its threshold voltage, the n type inversion layer is closed, thereby stopping injection of electrons, and at the same time, stopping the inflow of holes, thereby causing the device to become off-state. In this device having the structure described above, an area of n+ conducting type semiconductor layer 943, p+ conducting type semiconductor layer 95, n- conducting type semiconductor layer 99, n conducting type semiconductor layer 96 and p+ conducting type semiconductor layer 97 constitute a thyrister. Since this thyrister is caused to operate when in on-state, carriers are readily accumulated within n- conducting type semiconductor layer 99, thereby achieving a feature to attain a low on-voltage. Also in this device, a local life time controlled portion is provided in a place at the end of its depletion layer and including partially both n- conducting type semiconductor layer 99 and n conducting type semiconductor layer 96. Description of its low loss feature is omitted since it is clear from the description hereinabove.

Further, the present invention is not limited to those devices having the structures described hereinabove, but may be applicable to any semiconductor device effectively which is provided with a local life time controlled portion either in the end of its depletion layer extending from the main junction or in a region which includes n conducting type semiconductor layer which blocks expansion of the depletion layer, if provided in the device, and n- conducting type semiconductor layer. Also, it should be construed that the p conducting type and n conducting type semiconductor layer may be inverted to the same effect and advantage.

Fig. 10 is a schematic diagram of an inverter circuit for a three-phase induction motor in which the circuit of Fig. 2(a) or Fig. 6 is applied. In this arrangement, two switching elements (i.e., IGBT11 and IGBT12) are connected in series for each phase. Further, free-wheeling diode $D_F$ is connected in parallel with each switching device. Still further, each switching device is provided with a snubber circuit S connected in parallel therewith for protection thereof from a surge voltage at the time of switching. This snubber circuit is comprised of diode DS and resistance RS which are connected in parallel, and capacitance CS which is connected in series with the above-mentioned parallel circuit of DS and RS. Each junction node between two switching devices provided for each phase is connected to AC terminals T3, T4 or T5. Respective AC terminals are connected to the three-phase induction motor. Respective anode terminals of respective switching devices in the upper arm portion of Fig. 10 are connected to a common line, which at DC terminal T1 is connected with a high voltage side of a DC power supply. Cathode electrodes of three switching devices in the bottom arm portion are connected to a common line, which is connected at DC terminal T2 to a low voltage side of the DC power supply. In this device having the arrangement described above, DC is converted to AC through switching operation of each switching element therein for driving the three-phase induction motor.

Operation of the inverter circuit of Fig. 10 is omitted since it can be understood clearly from the description of the operation of the circuit of Fig. 2(a). Although it is needless to mention, IGBTs used in this circuit as switching elements are ones manufactured according to the invention, and which are applied with a voltage equal to or over that at which its depletion layer becomes punched through. Further, the diodes used in conjunction with IGBTs are ones having a structure that can withstand the punch-through of its depletion layer extending from its main junction even at the power supply voltage. Thereby, enabling the switching speed of IGBTs to become faster, and minimizing the turn-on and turn-off losses as well as the on-state loss. Further, the recovery noise which occurs when the diode recovers upon turn-on of IGBT can be prevented. Still further, the power converter apparatus according to this embodiment of the invention is described to have the snubber circuit including diode, resistance and capacitance, however, this snubber circuit can be omitted if inductance $L_L$ of the wiring in the main circuit is small and also the leap voltage which occurs during switching operation is small enough not to cause device destruction.

As described hereinabove, since the end portion of the depletion layer which extends from the main junction toward the collector electrode is provided with the local life time control according to the invention, the hole injection from the p collector layer can be eliminated, thereby remarkably reducing the turn-off loss without increasing the on-voltage. Further, the combination of the IGBT with the diode in which its depletion layer does not punch through even at the power supply voltage can prevent the recovery noise of the diode which occurs at faster turn-on speed, thereby capable of providing the power converter in which electromagnetic noise is minimized.

## Claims

1. A semiconductor switching device having:

    a pair of main electrode; and
    a control electrode for controlling switching of a current which flows between said pair of main electrodes, wherein there are provided between said pair of main electrodes, at least:
    a first semiconductor layer of a first conducting type;
    a second semiconductor layer of a second conducting type, which is provided adjacent to said first semiconductor layer; and
    a third semiconductor layer of a first conducting type, which is provided adjacent to said second semiconductor layer, wherein said second semiconductor layer comprises:
    a local life time controlled region in which a carrier life time is locally controlled, and wherein an end portion of a depletion layer which extends from a junction between said second semiconductor layer and said third semiconductor layer into said second semiconductor layer is ensured to reach said local life time controlled portion under application of a power supply voltage.

2. A semiconductor switching device according to claim 1, wherein said local life time controlled portion is formed in a place which includes in part an inside of said depletion layer, end portion and outside thereof.

3. A semiconductor switching device according to claim 1, wherein said second semiconductor layer comprises:

    a first portion which is adjacent to said first semiconductor layer; and
    a second portion which is adjacent to said third semiconductor layer, and has an impurity concentration which is lower than that of said first portion, and wherein
    said local life time controlled region is positioned in an area which includes said first portion and said second portion.

4. A semiconductor switching device according to claim 3, comprising a relationship that

$$E1 \geqq \{(q \cdot Nn^-)/(2 \cdot \varepsilon s)\} \cdot (Wn^-)^2$$

where, E1(V) is said power supply voltage, Nn⁻

(cm$^{-3}$) is an impurity concentration of said second portion, Wn$^-$(cm)is a thickness of said second portion, q(C)is a charge quantity of electrons, and εs (F/cm) is a dielectric constant of a semiconductor material of said second portion.

5. A semiconductor switching device according to claims 3 or 4, wherein said local life time controlled region is formed through provision of a carrier life time control using helium.

6. A semiconductor switching device according to claim 5, wherein said helium is injected into the device in a direction from the side of said first semiconductor layer to the side of said second semiconductor layer.

7. A semiconductor switching device according to claim 1, further comprising a fourth semiconductor layer which is formed within said third semiconductor layer, wherein

   one of said pair of main electrodes is formed in contact with said first semiconductor layer;
   the other one of said pair of main electrodes is formed in contact with said third semiconductor layer and said fourth semiconductor layer; and said control electrode is an insulated gate electrode which is formed via an insulation film on the surface of said third semiconductor layer.

8. A semiconductor switching device according to claim 7, wherein said local life time controlled region is positioned in an area which includes in part an inside portion, an end portion and an outside portion of said depletion layer.

9. A semiconductor switching device according to claim 7, wherein said second semiconductor layer comprises:

   a first portion which is adjacent to said first semiconductor layer; and
   a second portion which is adjacent to said third semiconductor layer, and has an impurity concentration which is lower than that of said first portion, and wherein
   said local life time controlled region is positioned in an area which includes in part said first and said second portions.

10. A semiconductor switching device according to claim 9, comprising a relationship that

$$E1 \geqq \{(q \cdot Nn^-)/(2 \cdot \varepsilon s)\} \cdot (Wn^-)^2$$

where, E1(V) is said power supply voltage, Nn$^-$

(cm$^{-3}$) is an impurity concentration of said second portion, Wn$^-$(cm)is a thickness of said second portion, q(C) is a charge quantity of electrons, and εs (F/cm) is a dielectric constant of a semiconductor material of said second portion.

11. A semiconductor switching device according to claims 9 or 10, wherein said local life time controlled region is formed through provision of a carrier life time control using helium.

12. A semiconductor switching device according to claim 7, wherein said helium is injected in a direction from the side of said first semiconductor layer to said second semiconductor layer.

13. A semiconductor switching device having:

   a first semiconductor layer of a first conducting type;
   a second semiconductor layer of a second conducting type which is adjacent to said first semiconductor layer;
   a third semiconductor layer of the first conducting type which is adjacent to said second semiconductor layer;
   a fourth semiconductor layer of the second conducting type which is formed within said third semiconductor layer;
   one of a pair of main electrodes which is in contact with said first semiconductor layer;
   the other one of said pair of the main electrodes which is in contact with said third and said fourth semiconductor layers;
   an insulated gate electrode which is formed on the surface of said third semiconductor layer via an insulation film, wherein said second semiconductor layer comprises:
   a first portion which is adjacent to said first semiconductor layer; and
   a second portion which is adjacent to said third semiconductor layer, and has an impurity concentration which is lower than that of said first portion, and wherein
   helium is distributed in a region which includes in part said first and said second portions, and further comprising a relationship that

$$E1 \geqq \{(q \cdot Nn^-)/(2 \cdot \varepsilon s)\} \cdot (Wn^-)^2$$

where, E1(V) is said power supply voltage, Nn$^-$ (cm$^{-3}$) is an impurity concentration of said second portion, Wn$^-$(cm)is a thickness of said second portion, q(C) is a charge quantity of electrons, and εs(F/cm) is a dielectric constant of a semiconductor material of said second portion.

**14.** A power converter apparatus which supplies an electric power from a power supply to a load by controlling on/off operation of a semiconductor switching device, wherein said semiconductor switching device has a semiconductor substrate comprising:

a pair of main electrodes;

a control electrode which controls a current flowing between said pair of main electrodes;

a main junction including at least a semiconductor layer of a first conducting type and another semiconductor layer of a second conducting type which are adjacent to each other, and wherein

a local carrier life time controlled region in which carrier life time is controlled locally is formed; and

an end portion of a depletion layer which extends from said main junction is ensured to reach said local carrier life time controlled region when said power supply voltage is applied across said pair of main electrodes of said semiconductor switching device.

**15.** A method of driving a semiconductor switching device having a semiconductor substrate including a pair of main electrodes; a control electrode for controlling a current flowing between said pair of main electrodes; and a main junction between a semiconductor layer of a first conducting type and another semiconductor layer of a second conducting type adjacent to each other, wherein a local life time controlled region in which its carrier life time is controlled locally is formed, the method comprising the step of applying a voltage across said pair of main electrodes such that an end portion of a depletion layer which extends from said main junction is caused to reach said local life time controlled region.

# FIG.1

(a)

(b)

# FIG.2

(a)

(b)

UNFORM LIFE-TIME CONTROL

Vp

LOCAL LIFE-TIME CONTROL

TURN-OFF LOSS (NORMALIZED)

POWER SUPPLY VOLTAGE E1 (V)

13

# FIG.3

DISTANCE X(μm) OF PEAK HELIUM DISTRIBUTION
FROM JUNCTION BETWEEN P⁺ EMITTER LAYER
AND n BUFFER LAYER

(a)

| He IRRADIATION POSITION | X = 10 μm | X = 22 μm |
|---|---|---|
| OUTPUT CHARACT. (ROOM TEMP.) | | |

(b)

# FIG.4

(a)

(b)

## FIG.5

## FIG.7

# FIG.6

(a)

(b)

# FIG.8

(a)

(b)

## FIG.9

## FIG.10

## EUROPEAN SEARCH REPORT

**European Patent Office**

**Application Number**

EP 98 30 1292

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | WO 93 05535 A (ADVANCED POWER TECHNOLOGY) 18 March 1993 | 1-4, 7-10,14, 15 | H01L29/739 |
| Y | * page 29, line 24 - page 30, line 18; figures 25-27 * <br> * page 51, line 4 - page 52, line 20 * <br> --- | 5,6, 11-13 | |
| Y | KONISHI Y ET AL: "OPTIMIZED LOCAL LIFETIME CONTROL FOR THE SUPERIOR IGBTS" PROCEEDINGS OF THE 8TH. INTERNATIONAL SYMPOSIUM ON POWER SEMICONDUCTOR DEVICES AND IC'S (ISPSD), MAUI, HAWAII, MAY 20 - 23, 1996, <br> no. SYMP. 8, 20 May 1996, SALAMA C A T;WILLIAMS R K (EDS ), <br> pages 335-338, XP000598451 <br> * figure 4 * <br> --- | 5,6, 11-13 | |
| A | EP 0 423 721 A (TOKYO SHIBAURA ELECTRIC CO) 24 April 1991 <br> * claim 12; figure 1 * <br> --- | 1-15 | |
| A | EP 0 744 834 A (HITACHI LTD) 27 November 1996 <br> * figures 7A,7B,10A,10B * <br> --- | 1-15 | TECHNICAL FIELDS SEARCHED (Int.Cl.6) <br><br> H01L |
| A | EP 0 735 591 A (CONS RIC MICROELETTRONICA) 2 October 1996 <br> * figures 4,5 * <br> --- | 1 | |
| A | EP 0 746 040 A (CONS RIC MICROELETTRONICA) 4 December 1996 <br> * figure 7A * <br> --- | 1 | |
| | -/-- | | |

The present search report has been drawn up for all claims

| Place of search | Date of completion of the search | Examiner |
|---|---|---|
| BERLIN | 15 May 1998 | Juhl, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

**EUROPEAN SEARCH REPORT**

Application Number

EP 98 30 1292

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | AMARATUNGA G A J ET AL: "THE NEW GENERATION OF POWER SEMICONDUCTOR DEVICES" 1996 INTERNATIONAL SEMICONDUCTOR CONFERENCE, SINAIA, ROMANIA, OCT. 9 - 12, 1996, vol. VOL. 2, no. CONF. 19, 9 October 1996, INSTITUTE OF ELECTRICAL AND ELECTRONICS ENGINEERS, pages 469-478, XP000626512 * figure 10 * | 1 | |
| A | MOTTO E R ET AL: "NEW PROCESS TECHNOLOGIES IMPROVE IGBT MODULE EFFICIENCY" RECORD OF THE INDUSTRY APPLICATIONS CONFERENCE (IAS), ORLANDO, OCT. 8 - 12, 1995, vol. VOL. 2, no. CONF. 30, 8 October 1995, INSTITUTE OF ELECTRICAL AND ELECTRONICS ENGINEERS, pages 991-996, XP000546841 * figure 3A * | 1 | TECHNICAL FIELDS SEARCHED (Int.Cl.6) |
| A | NORIYUKI IWAMURO ET AL: "2ND GENERATION DUAL GATE MOS THYRISTOR" PROCEEDINGS OF THE 8TH. INTERNATIONAL SYMPOSIUM ON POWER SEMICONDUCTOR DEVICES AND IC'S (ISPSD), MAUI, HAWAII, MAY 20 - 23, 1996, no. SYMP. 8, 20 May 1996, SALAMA C A T;WILLIAMS R K (EDS ), pages 129-132, XP000598413 * figure 1 * | 1 | |

The present search report has been drawn up for all claims

| Place of search | Date of completion of the search | Examiner |
|---|---|---|
| BERLIN | 15 May 1998 | Juhl, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)